# EUROPÄISCHE PATENTSCHRIFT

(11) **EP 3 610 505 B1**
(45) Veröffentlichungstag und Bekanntmachung des Hinweises auf die Patenterteilung: **17.04.2024**
(21) Anmeldenummer: 18734106.0
(22) Anmeldetag: 07.06.2018
(51) Int. Cl.: H01L 23/62, H01L 23/051, H01L 21/60

(54) **LEISTUNGSELEKTRONISCHES SCHALTMODUL MIT EINEM DURCH ENTFERNUNG EINER ISOLATION AUSZUBILDENDEN FEHLERSTROMPFAD**
POWER ELECTRONIC SWITCHING MODULE WITH A CURRENT FAILURE PATH TO BE CREATED THROUGH ISOLATION REMOVAL
MODULE ÉLECTRONIQUE DE COMMUTATION DE PUISSANCE AVEC UN CHEMIN DE COURANT DE DÉFAILLANCE SUSCEPTIBLE D'ÊTRE FORMÉ PAR ENLÈVEMENT D'UNE ISOLATION

(30) Priorität: 09.06.2017 DE 102017209783
(43) Veröffentlichungstag der Anmeldung: 19.02.2020
(73) Patentinhaber: Siemens Energy Global GmbH & Co. KG, 81739 München (DE)
(72) Erfinder: STEGMEIER, Stefan, 81541 München (DE); BERTHOLD, Thomas, 80995 München (DE); SCHMITT, Daniel, 92353 Postbauer-Heng (DE); SCHREMMER, Frank, 90768 Fürth (DE)
(86) Internationale Anmeldenummer: PCT/EP2018/065088
(87) Internationale Veröffentlichungsnummer: WO 2018/224618

(56) Entgegenhaltungen:
- EP-A1- 2 490 256
- EP-A1- 2 530 711
- EP-A1- 2 940 731
- WO-A1-2018/219967
- DE-A1-102014 207 928

## Beschreibung

Die Erfindung betrifft ein leistungselektronisches Schaltmodul.

In der Leistungselektronik sind bei zahlreichen Anwendungen Energiewandlung und Energietransport sicherzustellen. Herkömmliche Leistungsmodule allerdings sind im Fehlerfall bzw. im Abschaltversagen nicht sicher elektrisch leitfähig oder nur mit sehr hohem Aufwand dauerhaft (externe Schutzschalter) elektrisch schaltbar.

Es sind Leistungsmodule bekannt, bei welchen im thermischen Fehlerfall (Ausdehnung, Explosion) ein sicherer dauerhafter Kontakt zwischen Emitter und Kollektor eines Leistungshalbleiters des Leistungsmoduls sichergestellt ist. Dies wird mittels mechanischer Vorrichtungen mit Federvorspannung gewährleistet, welche einen elektrischen Kontakt herstellen. Solche mechanischen Vorrichtungen benötigen jedoch viel Zeit. Ein sicherer und insbesondere schneller Conduct-On-Fail-Fall jedoch erfordert ein sehr schnelles Auslösen, vorzugsweise innerhalb weniger Millisekunden.

Zudem zeigen EP 2 530 711 A1 und EP 2 490 256 A1 leistungselektronische Anordnungen mit Mitteln zum Kurzschließen eines Leistungshalbleiters im Fehlerfall.

Es ist daher Aufgabe der Erfindung, ein verbessertes leistungselektronisches Schaltmodul zu schaffen, mittels welchem der Fehlerfall rasch und sicher gehandhabt werden kann.

Diese Aufgabe wird mit einem leistungselektronischen Schaltmodul mit den in Anspruch 1 angegebenen Merkmalen gelöst. Bevorzugte Weiterbildungen der Erfindung sind in den zugehörigen Unteransprüchen, der nachfolgenden Beschreibung und der Zeichnung angegeben.

Das erfindungsgemäße leistungselektronische Schaltmodul umfasst mindestens einen Leistungshalbleiter und einen an den Leistungshalbleiter elektrisch angebundenen ersten Schaltkontakt und einen an den Leistungshalbleiter elektrisch angebundenen zweiten Schaltkontakt, wobei erster und zweiter Schaltkontakt zumindest in einem Bereich zueinander kraftbeaufschlagt und mittels einer elektrischen Isolation voneinander beabstandet sind, wobei die Isolation derart angeordnet und ausgebildet ist, dass sie infolge Bestromung des Leistungshalbleiters mit einem Fehlerstrom entfernbar ist.

Erfindungsgemäß löst also der Fehlerfall und die damit einhergehende Bestromung des Leistungshalbleiters mit einem Fehlerstrom die Entfernung der den ersten und den zweiten Schaltkontakt beabstandenden Isolation aus. Folglich werden erster und zweiter Schaltkontakt im Fehlerfall nicht weiter durch die Isolation beabstandet und treten aufgrund der Kraftbeaufschlagung aufeinander zu miteinander elektrisch leitend in Kontakt und bilden einen alternativen Fehlerstrompfad aus.

Vorzugsweise ist bei dem erfindungsgemäßen leistungselektronischen Schaltmodul die Isolation infolge Bestromung des Leistungshalbleiters jedenfalls dort entfernbar, wo die Isolation bei ausbleibender Bestromung den ersten und den zweiten Schaltkontakt voneinander beabstandet. Es ist völlig ausreichend, wenn die Isolation so weit entfernt wird, dass der erste und der zweite Schaltkontakt aufgrund der Entfernung der Isolation nicht weiter beabstandet werden sondern zur Ausbildung eines alternativen Fehlerstrompfades miteinander elektrisch leitend in Kontakt treten.

In einer vorteilhaften Weiterbildung des erfindungsgemäßen leistungselektronisches Schaltmoduls ist die Isolation mit einem Thermoplast und/oder einem Duroplast gebildet. Die Isolation ist in dieser Weiterbildung also derart entfernbar, dass die Isolation infolge des thermischen Fehlerfalls in ein Schmelzprodukt (Schmelztropfen) oder ein Gas oder ein Aerosol oder ein Pulver überführt wird, welches vorzugsweise aufgrund des sich vom Leistungshalbleiter ausbildenden Drucks in Richtung vom Leistungshalbleiter weg fortgetragen wird, sodass zumindest temporär die Isolation entfernbar ist. Bei dem erfindungsgemäßen leistungselektronischen Schaltmodul ist vorzugsweise die Isolation aus oder mit Polyamid und/oder Polyimid und/oder PEEK (Polyetheretherketon) und/oder PE (Polyethylen) und/oder PP (Polypropylen) und/oder einem oder mehreren weiteren Materialien gebildet.

Es erstreckt sich bei dem erfindungsgemäßen leistungselektronischen Schaltmodul die Isolation von einem am ersten und/oder zweiten Schaltkontakt befindlichen Oberflächenabschnitt des Leistungshalbleiters bis zu dem Bereich. Der am Leistungshalbleiter auftretende thermische Fehlerfall kann die Entfernung der Isolation am Oberflächenabschnitt des Leistungshalbleiters auslösen, also gewissermaßen "zünden". Im weiteren Verlauf kann sich dann die Isolation mit einer sich weiter vom Leistungshalbleiter entfernenden Entfernungsfront entfernen, bis sich die Isolation in dem Bereich, an/in welchem erster und zweiter Schaltkontakt zueinander kraftbeaufschlagt sind, entfernt. Besonders vorteilhaft ist die Isolation an dem Oberflächenabschnitt des Leistungshalbleiters auf den Fehlerfall besonders sensitiv, sodass in dieser Weiterbildung der Erfindung der Fehlerfall besonders rasch und zuverlässig gehandhabt werden kann.

Bei dem erfindungsgemäßen leistungselektronischen Schaltmodul ist der Bereich, in zumindest diesem der erste und der zweite Schaltkontakt zueinander kraftbeaufschlagt sind, von dem Leistungshalbleiter beabstandet.

In einer vorteilhaften Weiterbildung des erfindungsgemäßen leistungselektronischen Schaltmoduls umfasst dieses einen ersten Teil, bei welchem der zweite Schaltkontakt ein zweiter Teil ist und der erste Schaltkontakt mittels des ersten Teils kraftbeaufschlagt ist. Zweckmäßig bilden der erste Teil einen Boden und der zweite Teil einen Deckel oder der erste Teil einen Deckel und der zweite Teil einen Boden des erfindungsgemäßen leistungselektronischen Schaltmoduls.

Bei dem leistungselektronischen Schaltmodul gemäß der Erfindung wird/werden vorzugsweise der erste und/oder der zweite Schaltkontakt mittels eines Abstandshalters kraftbeaufschlagt.

Bei dem erfindungsgemäßen leistungselektronischen Schaltmodul ist vorteilhaft der Abstandshalter relativ zum Leistungshalbleiter betrachtet an einem Randbereich des Schaltmoduls angeordnet und/oder der Abstandshalter umgibt den zumindest einen Leistungshalbleiter umfänglich, zumindest teilumfänglich, vorzugsweise zumindest halbumfänglich, insbesondere vollumfänglich.

Geeigneterweise ist bei dem leistungselektronischen Schaltmodul der Leistungshalbleiter mit einem Leiter als dem ersten Schaltkontakt elektrisch kontaktiert und die Isolation bildet einen Träger für den Leiter. Auf diese Weise kann bei einem Fehlerfall des Leistungshalbleiters der Fehlerstrom über den Leiter fließen, wobei der Stromfluss über den Leiter das Fortschreiten einer Entfernungsfront der Entfernung der Isolation unterstützt und der Leiter das Fortschreiten der Entfernungsfront gewissermaßen führt.

Nachfolgend wird die Erfindung anhand eines in der Zeichnung dargestellten Ausführungsbeispiels näher erläutert. Es zeigen
- Figur 1: ein erfindungsgemäßes leistungselektronisches Schaltmodul mit einem Leistungshalbleiter und einem ersten und einem zweiten je daran angebundenen elektrischen Schaltkontakt, welche mittels einer Isolation voneinander getrennt sind, beim Auftreten des Fehlerfalls schematisch im Längsschnitt,
- Figur 2: das erfindungsgemäße leistungselektronische Schaltmodul gemäß Figur 1 in einer ersten Phase einer Fortleitung eines Fehlerstroms schematisch im Längsschnitt,
- Figur 3: das erfindungsgemäße leistungselektronische Schaltmodul gemäß Figur 1 in einer zweiten Phase der Fortleitung des Fehlerstroms schematisch im Längsschnitt sowie
- Figur 4: das erfindungsgemäße leistungselektronische Schaltmodul gemäß Figur 1 in einer letzten Phase der Fortleitung des Fehlerstroms schematisch im Längsschnitt.

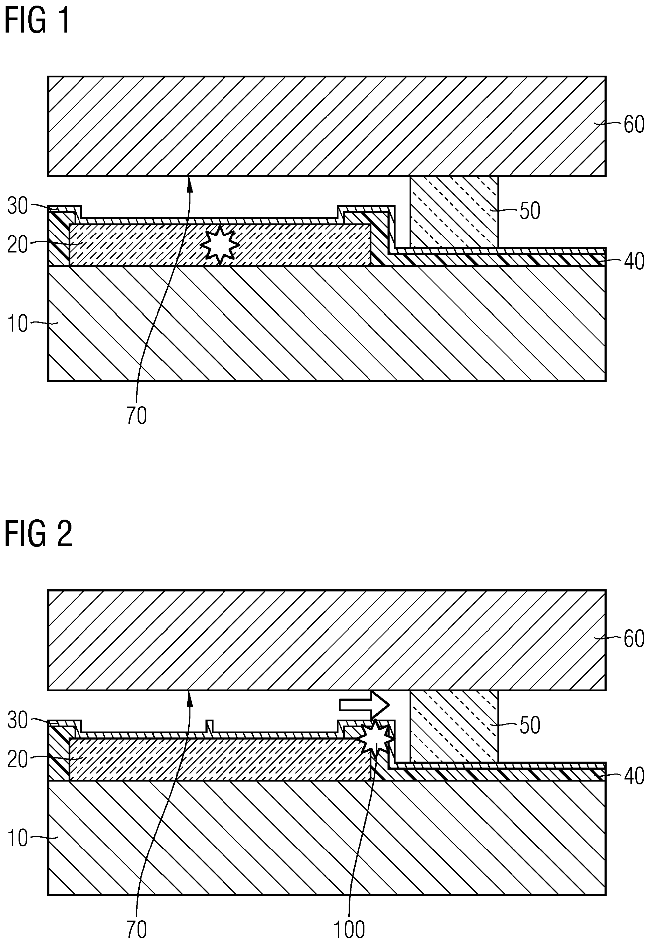

Das in Figur 1 dargestellte erfindungsgemäße leistungselektronische Schaltmodul weist einen auf Kollektorpotential befindlichen Boden 10 auf, welcher einen Leistungshalbleiter 20 trägt. Der Leistungshalbleiter 20 ist als Flachteil ausgebildet, welches zwei einander abgewandte Flachseiten aufweist. Eine Flachseite des Leistungshalbleiters 20 bildet das Kollektorpotential, welches vollflächig auf dem Boden 10 aufliegt. Eine vom Boden 10 abgewandte Flachseite des Leistungshalbleiters 20 bildet ein Emitterpotential des als Transistor ausgebildeten Leistungshalbleiters 20 aus, welches mittels einer planaren Aufbau- und Verbindungstechnologie, d.h. mittels einer planaren Leiterbahn 30, kontaktiert ist. Unter einer planaren Leiterbahn 30 ist eine Leiterbahn 30 zu verstehen, welche jeweils zumindest abschnittsweise flächig an dem Leistungshalbleiter 20 oder flächig an an diesem angrenzenden Isolierungen oder weiteren Komponenten des leistungselektronischen Schaltmoduls anliegt. Das Emitterpotential des Leistungshalbleiters 20 bildet einen ersten Schaltkontakt und das Kollektorpotential des Leistungshalbleiters 20 bildet einen zweiten Schaltkontakt, zwischen welchen der Leistungshalbleiter 20 schaltet. Das Emitterpotential bildet folglich einen ersten Schaltkontakt und das Kollektorpotential bildet folglich einen zweiten Schaltkontakt, zwischen welchen der Leistungshalbleiter 20 schaltet.

Die Leiterbahn 30 ist am Rand des Leistungshalbleiters 20 von der vom Boden 10 fernen Flachseite des Leistungshalbleiters 20 mittels einer aus einem Thermoplast, hier PEEK, gebildeten Isolierschicht 40 beabstandet, welche den Leistungshalbleiter 20 in Richtung der flächigen Erstreckung der Flachseiten des Leistungshalbleiters 20 als vollumfängliche Schicht an dem Leistungshalbleiter 20 umschließt und in eine den Boden 10 bedeckende Isolierschicht übergeht. Fern dem Leistungshalbleiter 20 weist die Isolierschicht 40 eine geringere Dicke senkrecht zu den Flachseiten des Leistungshalbleiters 20 auf als der Leistungshalbleiter 20. Die Leiterbahn 30, welche als Kupferleiterbahn ausgebildet ist, führt vom Leistungshalbleiter 20 auf solche vom Leistungshalbleiter 20 fernen Bereiche der Isolierschicht 40.

Mithin ist die Leiterbahn 30 an diesen vom Leistungshalbleiter 20 fernen Bereichen der Isolierschicht 40 räumlich dem Kollektorpotential näher als am Leistungshalbleiter 20 anliegende Abschnitte der Leiterbahn 30.

An einem solchen, dem Leistungshalbleiter fernen Bereich der Isolierschicht 40 stützt sich von dieser Isolierschicht 40 ein Abstandshalter 50 vom Boden 10 und von der Isolierschicht 40 und von der darauf befindlichen Leiterbahn 30 ab. Der Abstandshalter 50 trägt einen Deckel 60 und beabstandet diesen vom Boden 10. Der Abstandshalter 50 ist im Wesentlichen kreiszylindrisch ausgebildet und streckt sich mit seiner Längsmittelachse senkrecht vom Boden 10 fort. Der Deckel 60 ist im Wesentlichen eben und flach ausgebildet und weist eine dem Boden 10 zugewandte und parallel zu den Flachseiten des Leistungshalbleiters 20 sich erstreckende Flachseite 70 auf.

Im in Figur 1 dargestellten Fehlerfall schließen der erste und zweite Schaltkontakt am Leistungshalbleiter 20 kurz, so dass ein großer Fehlerstrom durch den Leistungshalbleiter 20 zu fließen beginnt. Am Rand des Leistungshalbleiters 20 (betrachtet in Richtung der flächigen Erstreckungen der Flachseiten des Leistungshalbleiters 20) beginnt der Fehlerstrom zwischen der Leiterbahn 30 und dem Boden 10 das zwischen der Leiterbahn 30 und dem Boden 10 befindliche Thermoplast, das die Isolierschicht 40 bildet, aufzuschmelzen bzw. zu pulverisieren (Figur 2). Der im Inneren entstehende Druck befördert dieses nach außen. Die Isolierschicht 40 entfernt sich mit einer sich von dem Leistungshalbleiter 20 entfernenden Entfernungsfront 100 (Figuren 2, 3 und 4), bis diese Entfernungsfront 100 denjenigen Bereich der Isolierschicht 40 erreicht, an welchem sich der Abstandshalter 50 abstützt.

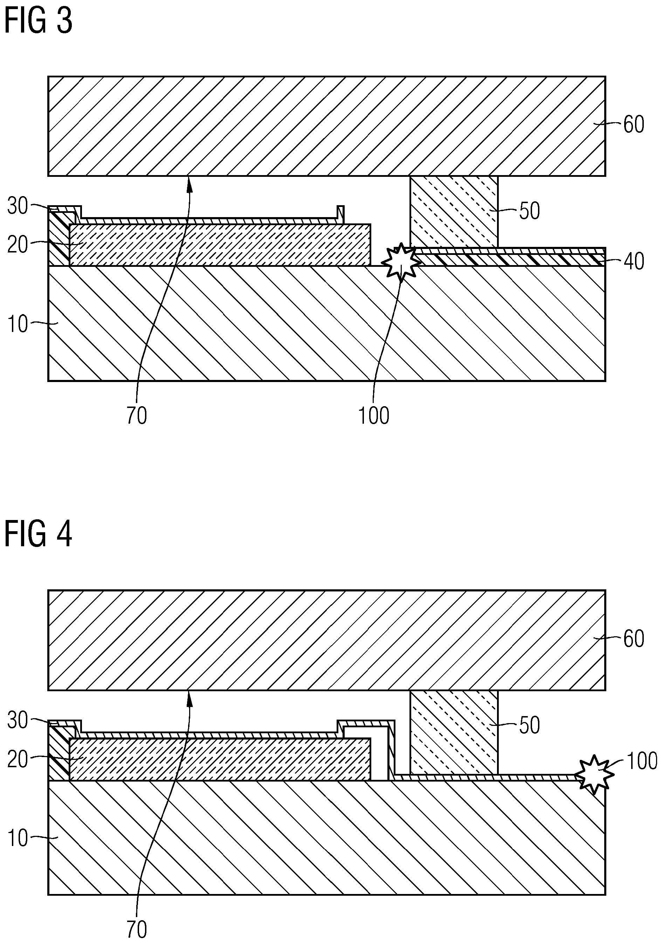

Aufgrund der Entfernung dieses Bereichs der Isolierschicht 40 drückt der Abstandshalter 50 die Leiterbahn 30 auf den Boden 10 (Figur 4), sodass mittels der Leiterbahn 30 und des Abstandshalters 50 und des Bodens 10 ein alternativer Fehlerstrompfad für den Fehlerstrom realisiert ist. Der Abstandshalter 50, die Leiterbahn 30 und der Boden 10 verschmelzen miteinander aufgrund eines infolge der Fehlerstromstärke resultierenden Diffusionslötprozesses, so dass der alternative Fehlerstrompfad durch stoffschlüssige Verbindung bis zu einem Abschalten des Schaltmoduls dauerhaft fehlerstromfest sichergestellt ist.

In weiteren, nicht eigens dargestellten Ausführungsbeispielen können anstelle einer planaren Leiterbahn 30 auch in an sich bekannter Weise Drahtbonds, welche mittels Kupferdrähten gebildet sind, vorgesehen sein. D.h. anstelle der planaren Aufbau- und Verbindungstechnologie kommt zur Kontaktierung des Leistungshalbleiters 20 eine herkömmliche Drahtbondtechnologie zum Einsatz.

In weiteren, nicht eigens dargestellten Ausführungsbeispielen, welche den vorhergehend beschriebenen Ausführungsbeispielen im Übrigen entsprechen, ist jeweils anstelle eines kreiszylindrischen Abstandshalters 50 ein ringförmiger Abstandshalter 50 vorhanden, welcher den Leistungshalbleiter 20 vollumfänglich, d.h. in der Ebene der Flachseiten des Leistungshalbleiters 20 umfänglich, umgibt. Auf diese Weise wird die Entfernungsfront aufgrund des im Leistungshalbleiter 20 entstehenden Drucks stets in Richtung des umfänglichen Abstandshalters getrieben. Dieses Prinzip kann auch auf eine Gruppe von Leistungshalbleitern mit einem um die Gruppe befindlichen umfänglichen Abstandshalter übertragen werden.

In weiteren, nicht eigens dargestellten Ausführungsbeispielen ist die Isolierschicht 40 mit einem anderen Thermoplast, beispielsweise mit Polyamid und/oder Polyimid und/oder PE und/oder PP gebildet. Ferner kann in weiteren, nicht eigens dargestellten Ausführungsbeispielen die Isolierschicht 40 auch stattdessen mit einem Duroplast gebildet sein.

## Patentansprüche

1. Leistungselektronisches Schaltmodul, umfassend mindestens einen als Flachteil ausgebildeten Leistungshalbleiter (20) mit zwei einander abgewandten Flachseiten und einen an den Leistungshalbleiter (20) elektrisch angebundenen ersten Schaltkontakt (30) und einen an den Leistungshalbleiter (20) elektrisch angebundenen zweiten Schaltkontakt (10), wobei die zweite Flachseite des Leistungshalbleiters (20) mit dem zweiten Schaltkontakt (10) angebunden ist, wobei der erste (30) und der zweite (10) Schaltkontakt zumindest in einem von dem Leistungshalbleiter (20) beabstandenen Bereich zueinander kraftbeaufschlagt und mittels einer elektrischen Isolation (40) voneinander beabstandet sind, wobei die Isolation (40) derart angeordnet und ausgebildet ist, dass sie infolge Bestromung des Leistungshalbleiters (20) mit einem Fehlerstrom entfernbar ist, so dass der erste (30) und der zweite (10) Schaltkontakt in einem mit dem Fehlerstrom verbundenen Fehlerfall nicht weiter durch die Isolation (40) beabstandet werden und aufgrund der Kraftbeaufschlagung aufeinander zu miteinander elektrisch leitend in Kontakt treten und einen alternativen Fehlerstrompfad ausbilden, **dadurch gekennzeichnet, dass**
die erste Flachseite des Leistungshalbleiters (20) mit dem ersten Schaltkontakt (30) angebunden ist und
sich die Isolation (40) von einem am ersten (30) und/oder zweiten (10) Schaltkontakt befindlichen Oberflächenabschnitt des Leistungshalbleiters (20) bis zu dem Bereich erstreckt.

2. Leistungselektronisches Schaltmodul nach Anspruch 1, bei welchem die Isolation (40) infolge Bestromung des Leistungshalbleiters (20) jedenfalls dort entfernbar ist, wo die Isolation (40) bei ausbleibender Bestromung den ersten (30) und den zweiten Schaltkontakt (10) voneinander beabstandet.

3. Leistungselektronisches Schaltmodul nach einem der vorhergehenden Ansprüche, bei welchem die Isolation (40) mit einem Thermoplast und/oder einem Duroplast gebildet ist.

4. Leistungselektronisches Schaltmodul nach einem der vorhergehenden Ansprüche, bei welchem die Isolation (40) aus oder mit Polyamid und/oder Polyimid und/oder Polyetheretherketon, PEEK, und/oder Polyethylen, PE, und/oder Polypropylen, PP, gebildet ist.

5. Leistungselektronisches Schaltmodul nach einem der vorhergehenden Ansprüche, umfassend einen ersten Teil (60), bei welchem der zweite Schaltkontakt (10) ein zweiter Teil (10) ist und der erste Schaltkontakt (30) mittels des ersten Teils (60) kraftbeaufschlagt ist.

6. Leistungselektronisches Schaltmodul nach einem der vorhergehenden Ansprüche, bei welchem der erste (30) und/oder der zweite Schaltkontakt (10) mittels eines Abstandshalters (50) kraftbeaufschlagt werden/wird.

7. Leistungselektronisches Schaltmodul nach dem vorherigen Anspruch, bei welchem der Abstandshalter (50) einem relativ zum Leistungshalbleiter (20) randständigen Bereich des Schaltmoduls angeordnet ist und/oder den Leistungshalbleiter (20) umfänglich, insbesondere vollumfänglich, umgibt.

8. Leistungselektronisches Schaltmodul nach einem der vorhergehenden Ansprüche, bei welchem der Leistungshalbleiter (20) mit einem Leiter als dem ersten Schaltkontakt (30) elektrisch kontaktiert ist und die Isolation (40) einen Träger für den Leiter bildet.

## Claims

1. Power electronic switching module, comprising at least one power semiconductor (20) configured as a flat part having two flat sides facing away from one another, and a first switching contact (30) electrically linked to the power semiconductor (20) and a second switching contact (10) electrically linked to the power semiconductor (20), wherein the second flat side of the power semiconductor (20) is linked to the second switching contact (10), wherein the first (30) and the second (10) switching contacts are subjected to force towards one another at least in a region spaced apart from the power semiconductor (20) and
are spaced apart from one another by means of an electrical insulation (40), wherein the insulation (40) is arranged and configured in such a way that it is removable owing to energization of the power semiconductor (20) with a fault current, with the result that, in a fault situation associated with the fault current, the first (30) and the second (10) switching contacts are no longer spaced apart by the insulation (40) and, on account of being subjected to force towards one another, make electrically conductive contact with one another and form an alternative fault current path, **characterized in that**
the first flat side of the power semiconductor (20) is linked to the first switching contact (30) and the insulation (40) extends from a surface section of the power semiconductor (20), said surface section being situated at the first (30) and/or second (10) switching contact, as far as the region.

2. Power electronic switching module according to Claim 1, wherein the insulation (40) is removable owing to energization of the power semiconductor (20) at any rate where the insulation (40) spaces apart the first switching contact (30) and the second switching contact (10) from one another in the absence of energization.

3. Power electronic switching module according to either of the preceding claims, wherein the insulation (40) is formed with a thermoplastic and/or a thermosetting plastic.

4. Power electronic switching module according to any of the preceding claims, wherein the insulation (40) is formed from or with polyamide and/or polyimide and/or polyether ether ketone, PEEK, and/or polyethylene, PE, and/or polypropylene, PP.

5. Power electronic switching module according to any of the preceding claims, comprising a first part (60), wherein the second switching contact (10) is a second part (10) and the first switching contact (30) is subjected to force by means of the first part (60).

6. Power electronic switching module according to any of the preceding claims, wherein the first switching contact (30) and/or the second switching contact (10) are/is subjected to force by means of a spacer (50).

7. Power electronic switching module according to the preceding claim,
wherein the spacer (50)
is arranged at a marginal region of the switching module relative to the power semiconductor (20) and/or surrounds the power semiconductor (20) peripherally, in particular fully peripherally.

8. Power electronic switching module according to any of the preceding claims, wherein the power semiconductor (20) is electrically contacted with a conductor as the first switching contact (30) and the insulation (40) forms a carrier for the conductor.

## Revendications

1. Module électronique de puissance de coupure, comprenant au moins un semi-conducteur (20) de puissance constitué sous la forme d'une pièce plane, ayant deux faces planes non tournées l'une vers l'autre et un premier contact (30) de coupure connecté électriquement au semi-conducteur (20) de puissance et un deuxième contact (10) de coupure connecté électriquement au semi-conducteur (20) de puissance, dans lequel la deuxième face plane du semi-conducteur (20) de puissance est connectée au deuxième contact (10) de coupure, dans lequel le premier (30) et le deuxième (10) contacts de coupure sont, au moins dans une région à distance du semi-conducteur (20) de puissance, soumis l'un par rapport à l'autre à une force et sont mis à distance l'un de l'autre, au moyen d'au moins un isolement (40) électrique, dans lequel l'isolement (40) est disposé et constitué, de manière à pouvoir, en raison d'une alimentation en courant du semi-conducteur (20) de puissance, être enlevé par un courant de défaillance, de sorte que le premier (30) et le deuxième (10) contacts de coupure ne sont plus, dans un cas de défaillance, reliés au courant de défaillance mis à distance par l'isolement (40) et, en raison de l'application de la force l'un par rapport à l'autre, entrent en contact, d'une manière conductrice de l'électricité, l'un avec l'autre et forment un chemin alternatif de courant de défaillance,
**caractérisé en ce que**
la première face plane du semi-conducteur (20) de puissance est connectée au premier contact (30) de coupure et
l'isolement (40) s'étend d'une première partie de surface, se trouvant sur le premier (30) et/ou le deuxième (10) contact de coupure du semi-conducteur (20) de puissance, jusqu'à la région.

2. Module électronique de puissance de coupure suivant la revendication 1, dans lequel l'isolement (40) peut être enlevé en raison de l'alimentation en courant du semi-conducteur (20) de puissance, en tout cas là où l'isolement (40), alors que l'alimentation en courant est absente, met à distance l'un de l'autre le premier (30) et le deuxième contacts (10) de coupure.

3. Module électronique de puissance de coupure suivant l'une des revendications précédentes, dans lequel l'isolement (40) est formé d'une résine thermoplastique et/ou d'une résine thermodurcissable.

4. Module électronique de puissance de coupure suivant l'une des revendications précédentes, dans lequel l'isolement (40) est formé par un polyamide et/ou un polyimide et/ou une polyétheréthercétone, PEEK, et/ou un polyéthylène, PE, et/ou un polypropylène, PP.

5. Module électronique de puissance de coupure suivant l'une des revendications précédentes, comprenant une première partie (60), dans lequel le deuxième contact (10) de coupure est une deuxième partie (10) et le premier contact (30) de coupure est soumis à une force au moyen de la première partie (60).

6. Module électronique de puissance de coupure suivant l'une des revendications précédentes, dans lequel le premier (30) et/ou le deuxième contact (10) de coupure est/sont soumis à une force au moyen d'une entretoise (50).

7. Module électronique de puissance de coupure suivant la revendication précédente, dans lequel l'entretoise (50) est disposée par rapport au semi-conducteur (20) de puissance dans une région de bord du module de coupure et/ou entoure le semi-conducteur (20) de puissance sur le pourtour, en particulier sur tout le pourtour.

8. Module électronique de puissance de coupure suivant l'une des revendications précédentes, dans lequel le semi-conducteur (20) de puissance est au contact électriquement d'un conducteur comme premier contact (30) de coupure et l'isolement (40) forme un support du conducteur.
